# EUROPÄISCHE PATENTSCHRIFT

(11) **EP 3 101 747 B1**
(45) Veröffentlichungstag und Bekanntmachung des Hinweises auf die Patenterteilung: **06.02.2019**
(21) Anmeldenummer: 16001205.0
(22) Anmeldetag: 27.05.2016
(51) Int. Cl.: H02G 3/18, H02G 9/10, H05K 7/20

(54) **UNTERFLURVERTEILER FÜR ELEKTRISCHE UND/ODER ELEKTRONISCHE EINRICHTUNGEN**
UNDERFLOOR DISTRIBUTOR FOR ELECTRICAL AND/OR ELECTRONIC UNITS
RÉPARTITEUR ENCASTRÉ POUR DISPOSITIFS ÉLECTRIQUES ET/OU ÉLECTRONIQUES

(30) Priorität: 03.06.2015 DE 102015006881
(43) Veröffentlichungstag der Anmeldung: 07.12.2016
(73) Patentinhaber: Langmatz GmbH, 82467 Garmisch-Partenkirchen (DE)
(72) Erfinder: Rüttiger, Steffen, 82490 Farchant (DE)
(74) Vertreter: Flosdorff, Jürgen

(56) Entgegenhaltungen:
- WO-A1-2008/106818
- DE-B3-102005 019 691
- US-A1- 2009 072 685

## Beschreibung

Die Erfindung betrifft einen Unterflurverteiler für elektrische und/oder elektronische Einrichtungen insbesondere der Telekommunikation, mit einem unterflur in den Boden einbaubaren Schacht, der Deckel und eine luftdichte Haube aufweist, in der die elektrischen und/oder elektronischen Einrichtungen angeordnet sind, wobei die Haube aus einer horizontalen Lage in eine vertikale Lage hochklappbar ist, damit Installations-, Bedienungs- und Wartungsarbeiten der Energieverteilung oder an den zugehörigen Komponenten durchgeführt werden können. In der horizontalen Ausgangslage schützt die luftdichte Haube die darin angeordneten Komponenten bei einem Wassereinbruch in den Schacht vor der Berührung mit dem Wasser, das nur in einer sehr geringen Höhe in die Haube unten eindringen kann.

Bei einem Betrieb der elektrischen/elektronischen Komponenten beispielsweise durch eine hohe Belegung von Teilnehmern bei Telekommunikationseinrichtungen entsteht eine große Verlustleistung, die so hohe Temperaturen unter der luftdichten Haube zur Folge haben kann, dass einzelne oder alle elektrischen oder elektronischen Komponenten ausfallen und sogar dauerhaft beschädigt werden können.

Die WO 2008/106818A1 offenbart einen Unterflurverteiler für elektrische und/oder elektronische Einrichtungen mit den Merkmalen des Oberbegriffs des Patentanspruchs 1. Bei diesem Unterflurverteiler sind die Mittel zur Erzeugung eines Kühlluftstroms durch die luftdichte Haube in dem Schacht in einem zweiten Schacht angeordnet, der an den die Haube enthaltenden Schacht angrenzt, und die Mittel zur Abfuhr von Wärme sind in einem dritten Schacht untergebracht, der an der gegenüber liegenden Stirnseite des die Haube enthaltenden Schachts, an diesen angrenzend, angeordnet ist.

Die US 2009/0072685 A1 offenbart ein System zur Unterflur-Anordnung von elektrischen und/oder elektronischen Einrichtungen, die in einem Gehäuse untergebracht sind, dessen Deckel aufklappbar ist. Damit ist dieses Gehäuse nicht luftdicht, so dass bei einem Wassereinbruch in den Schacht die elektrischen/elektronischen Einrichtungen überflutet würden. Innerhalb des Gehäuses befindet sich ein Teil einer Wärmetauschereinrichtung, deren anderer Teil sich außerhalb des Schachtes befindet. Die Schachtdeckel haben keine Belüftungsöffnungen.

Der vorliegenden Erfindung liegt die Aufgabe zugrunde, die schädliche Wärme wirkungsvoll abzuführen und dabei den Schutz vor eindringendem Wasser beizubehalten.

Diese Aufgabe wird erfindungsgemäß durch die Merkmale des Patentanspruchs 1 gelöst. Vorteilhafte Ausgestaltungen der Erfindung sind in den Unteransprüchen gekennzeichnet.

Die Erfindung sieht vor, dass kalte Zuluft durch wenigstens ein Lüftermodul in den Innenraum der luftdichten Haube gedrückt wird, dass die zunächst kalte Luftströmung in der Haube die dort entstandene Wärme aufnimmt und als erwärmte Abluft durch ein Lüftermodul aus der Haube abgesaugt und aus dem Schacht abgeführt wird. Hierzu hat wenigstens ein Deckel des Schachtes Öffnungen für kalte Zuluft und für die warme Abluft, wobei diese Öffnungen mit den zugehörigen Lüftermodulen in Verbindung stehen. Dies kann durch geeignete Rohre erfolgen. Von dem wenigstens einen Lüftermodul der Kaltluft-Druckseite führt eine zugehörige Rohrleitung in die Haube, deren Innenraum von der unter Druck zugeführten Zuluft durchströmt wird. Die Erfindung sieht weiter vor, dass die in der Haube erwärmte Abluft vorzugsweise durch einen biegsamen Schlauch aus der Haube heraus und in das zugehörige Lüftermodul der Warmluft-Saugseite eingesaugt wird, um von dort durch die Öffnung in den Deckel abgeführt zu werden. Der biegsame Schlauch ermöglicht eine sichere Anbindung an die luftdichte Haube, so dass diese aus der horizontalen Ruhelage in eine vertikale Arbeitslage hochzuklappen ist.

Die Lüftermodule haben jeweils einen in einer Schutzhaube angeordneten Lüfter. Die Saugseite des Kaltluft-Ventilators befindet sich an der Seite der Zuluftöffnung des Deckels, während die Druckseite des Ventilators mit einer Rohrleitung verbunden ist, die zu der luftdichten Haube führt. Das Lüftermodul weist Filter auf, durch die die durchströmende Kaltluft gereinigt wird, bevor sie in die Haube gelangt. Hierdurch wird eine hohe Staubbelastung der Komponenten in der Haube ausgeschlossen, die anderenfalls zu Ausfällen und Schäden führen könnte.

Es liegt im Rahmen der Erfindung, dass ein oder mehr Lüftermodule für die Kaltluft und auch ein oder mehr Lüftermodule für die erwärmte Abluft angeordnet sein können.

Außerdem sieht die Erfindung vor, dass in dem Schacht eine Querwand einen Technikraum von einem Einbauraum trennt, der die Haube mit den elektrischen/elektronischen Komponenten enthält. In dem Technikraum sind die Lüftermodule angeordnet.

In einer vorteilhaften Ausgestaltung der Erfindung ist vorgesehen, dass die luftdichte Haube eine schwenkbare Tür aufweist, durch die im hochgeklappten Zustand der Haube ein unbefugter Zugang zu den darin befindlichen Komponenten verhindert werden kann. In dieser Tür sind bevorzugt zwei Eintrittsöffnungen für die Kaltluft ausgebildet, die durch Rohre von den Lüftermodulen zugeführt wird.

Der untere Teil der hochgeklappten Haube kann durch eine stationäre Stirnwand geschlossen sein, an die die schwenkbare Tür anschließt. Dies ist dann zweckmäßig, wenn der Bereich hinter der stationären Stirnwand frei von den elektrischen und/oder elektronischen Einrichtungen ist. Diese stationäre Wand hat ein oder zwei Austrittöffnungen für die Warmluft. In dieser wenigstens einen Austrittsöffnung ist ein biegsamer Schlauch befestigt, der mit der zu dem zugehörigen Lüftermodul führenden Rohrleitung gekoppelt ist.

Mit großem Vorteil ist vorgesehen, dass in der luftdichten Haube Leitbleche angeordnet sind, die den Luftstrom entlang der Innenwand der Haube von der wenigstens einen Eintrittsöffnung zu der wenigstens einen Austrittöffnung führen. Ein Teil der Luftströmung verläuft dabei auch zwischen den elektrischen und/oder elektronischen Einrichtungen zur oberen Wand der horizontalen Haube und hinter einem vertikalen Luftleitblech am Ende der Einbauten zu der oder den Austrittöffnungen. Die Luftleitbleche sind so angeordnet, dass eine glatte Luftströmung größtenteils über den Einbauten, zu einem geringen Teil auch zwischen den Einbauten, zu dem in der horizontalen Lage rückwärtigen, von Einbauten freien Raum erfolgt, so dass die Wärme wirkungsvoll aus der Haube und schließlich aus dem Schacht abgeführt wird.

In der luftdichten Haube können mehrere Temperatursensoren in verschiedenen Höhen angeordnet sein, die zur Steuerung der Lüfter bzw. Gebläse herangezogen werden können. In dem Schacht kann ein PC angeordnet sein, der mit den Sensoren verbunden ist und diese auswertet. Wenn sich die Temperatur in der Haube nicht in dem erforderlichen Maß senken läßt, kann der PC einzelne oder alle elektrischen oder elektronischen Komponenten abschalten und gegebenenfalls einen Alarm an eine übergeordnete Leitwarte absetzen, die diese Abschaltung vornimmt. Die Ausbildung kann auch so getroffen sein, dass im Normalfall nur jeweils ein Lüfter für die Zuluft und für die Abluft läuft, und dass jeweils ein oder mehr zusätzliche Lüfter zugeschaltet werden, wenn die Temperatur in der Haube sich einem kritischen Wert nähert, oder die einzelnen Lüfter separat geregelt werden können.

Weitere Einzelheiten der Erfindung ergeben sich aus der nachfolgenden Beschreibung und den beigefügten Zeichnungen. Diese zeigen:
- Figur 1: den geschlossenen Schacht;
- Figur 2: den aufgeklappten Zustand der luftdichten Haube mit geöffneter Tür;
- Figur 3: einen Vertikalschnitt durch den Schacht mit Rohrleitungen der Zuluft und Abluft;
- Figur 4: einen schematischer Vertikalschnitt, der die Zuluft zeigt;

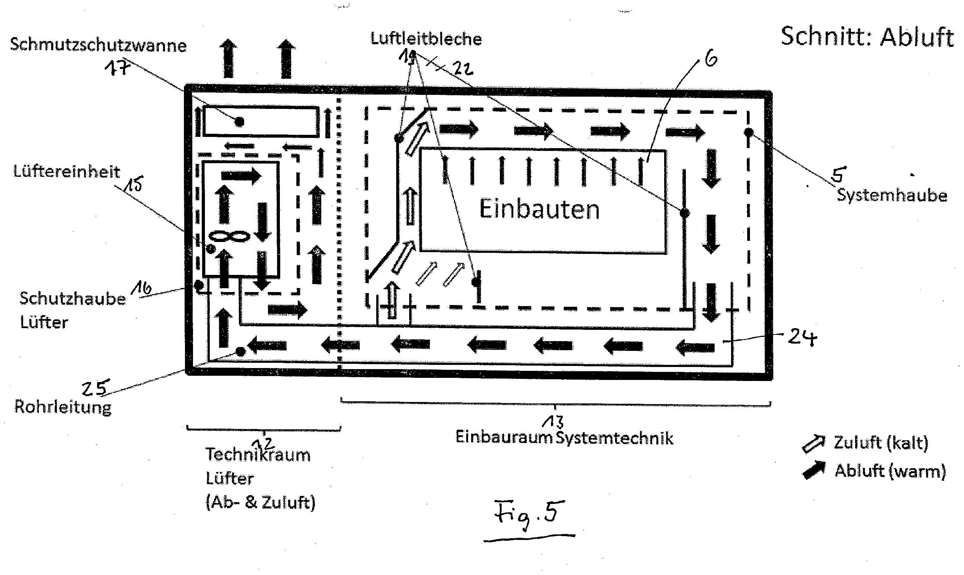

- Figur 5: einen schematischen Vertikalschnitt, der die Abluft zeigt;

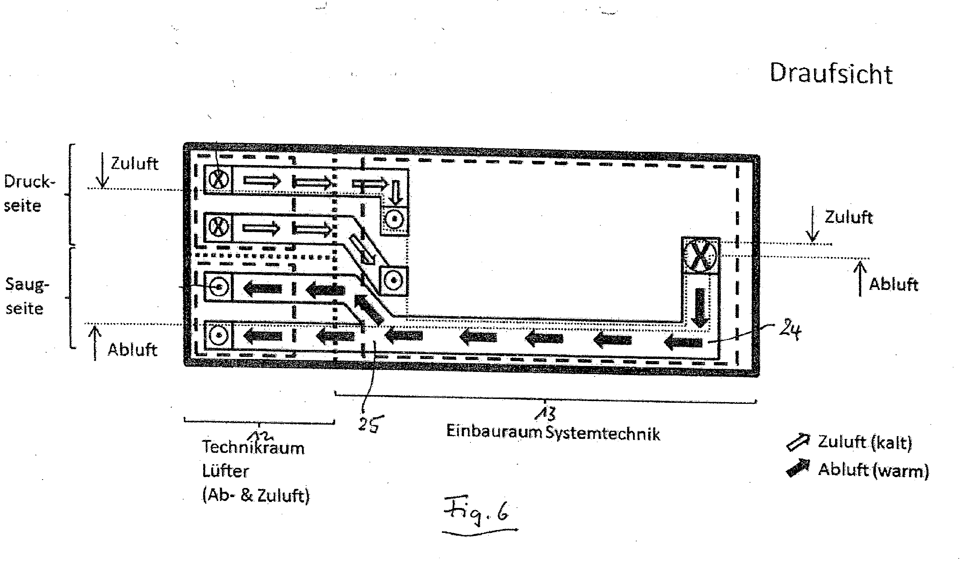

- Figur 6: eine Draufsicht auf die Luftströmung.

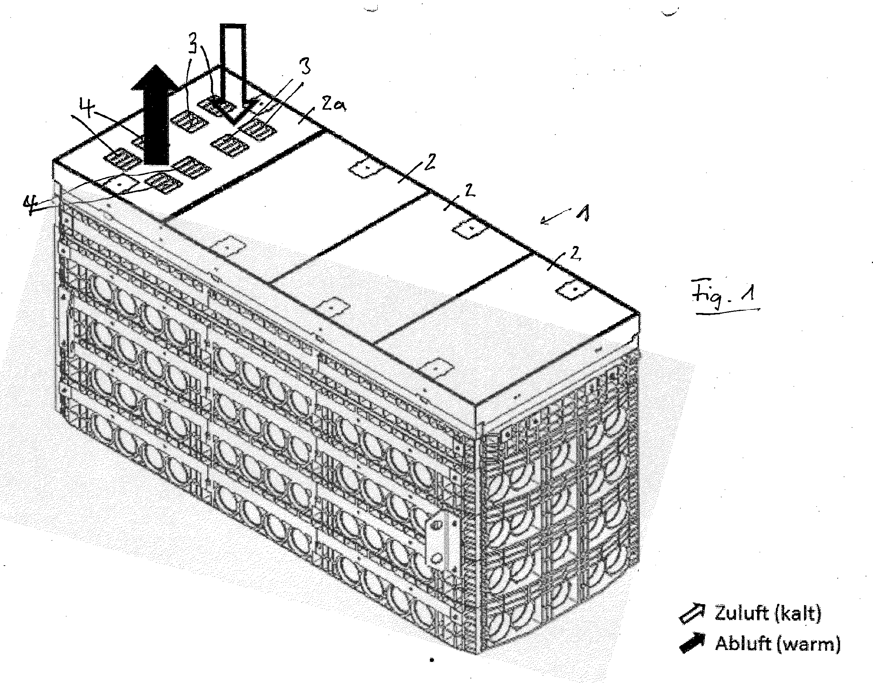

Figur 1 zeigt einen Kunststoffschacht 1, der durch vier Deckel 2 verschlossen ist. Ein am seitlichen Rand befindlicher Deckel 2a enthält vier Öffnungen 3 für kalte Zuluft und vier Öffnungen 4 für warme Abluft.

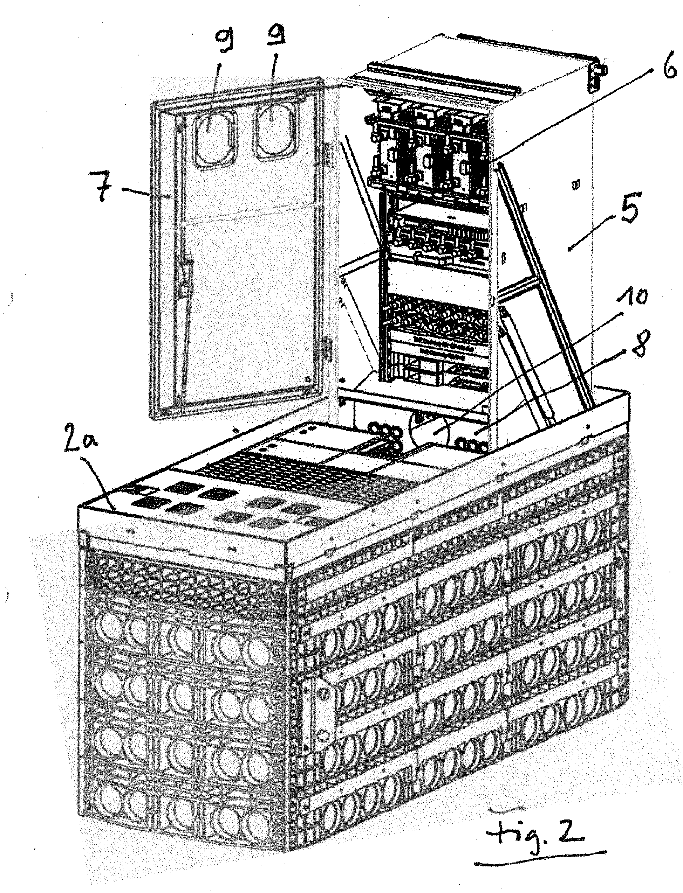

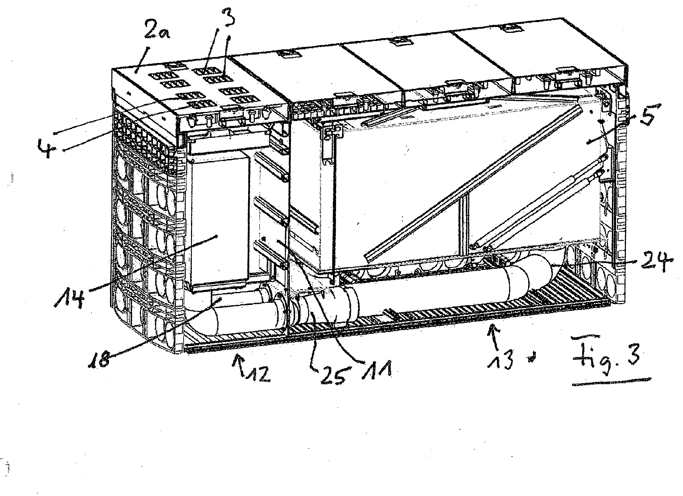

In dem Schacht ist eine luftdichte Haube 5 angeordnet, die aus ihrer horizontalen Ausgangslage (Figur 3) in eine vertikale Lage hoch klappbar ist, die Figur 2 zeigt. In der Haube 5 sind die Komponenten von elektrischen und/oder elektronischen Einrichtungen 6 der Telekommunikation angebracht. Die offene Seite der Haube 5 ist durch eine schwenkbare Tür 7 verschließbar, die sich bis zu einer darunter befindlichen, festen Stirnwand 8 der Haube erstreckt. Der Deckel 2a mit den Öffnungen 3 und 4 befindet sich an dem gegenüber liegenden Endbereich zu der hoch geklappten Haube 5.

Die Tür 7 enthält zwei nebeneinander liegende Eintrittsöffnungen 9 für die Kaltluft. Die untere Stirnwand 8 enthält eine Austrittsöffnung 10, an der der biegsame Schlauch befestigt ist, für die in der Haube erwärmte Abluft.

In dem Schacht 1 trennt eine Querwand 11 einen Technikraum 12 von einem Einbauraum 13 für die Systemtechnik, der vor allem die Haube 5 mit den elektrischen/elektronischen Komponenten 6 enthält. In dem Technikraum 12 sind Lüftermodule 14 angeordnet, die jeweils einen Lüfter 15 in einer Schutzhaube 16 aufweisen. Über den Lüftermodulen 14 befindet sich eine Schmutzschutzwanne 17, die die durch die Öffnungen 3 und 4 eingetretenen Schmutzpartikel auffängt.

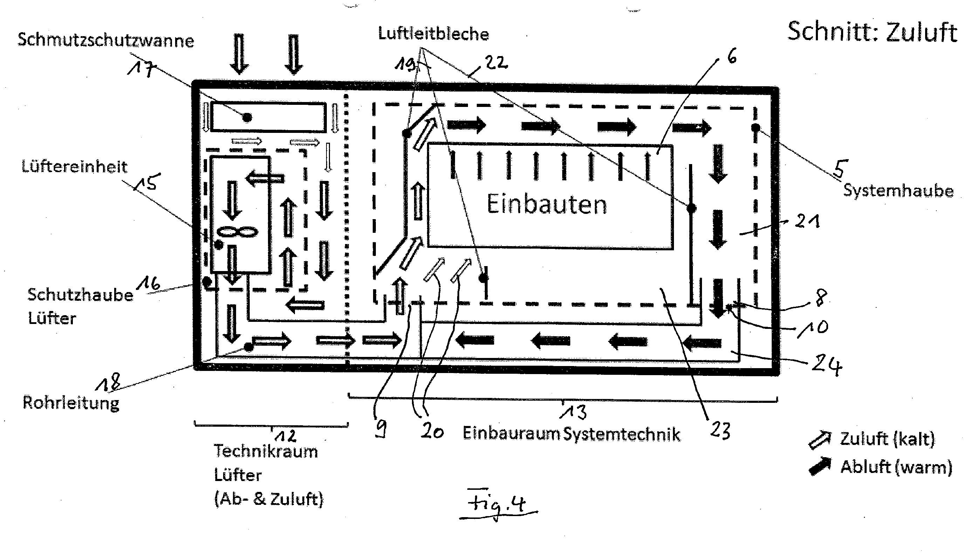

Die Zuluft wird von dem/den zugehörigen Lüftern 15 durch die Öffnungen 3 und anschließende Rohrleitungen in die Schutzhauben 16 mit den Lüftern 15 angesaugt, strömt durch (nicht dargestellte) Filter und wird durch Rohre 18 durch die Eintrittsöffnungen 9 ins Innere der Haube 5 eingeführt. Die Luftströmung der Zuluft ist in Figur 4 durch Pfeile dargestellt. Luftleitbleche 19 leiten die Luft in der Haube 5 größtenteils nahe der Innenwand der Haube 5 um die Einbauten 6 herum, wobei ein Teil der Zuluftströmung 20 auch durch die Einbauten nach oben gelenkt wird. Die Zuluft erwärmt sich auf ihrem Weg zu dem von Einbauten freien Raum 21, der von dem die Einbauten enthaltenden Raum 23 durch ein Luftleitblech 22 abgetrennt ist. Damit kann die dahinter strömende Abluft nicht wieder in den Bereich der Einbauten gelangen. Die erwärmte Abluft tritt vielmehr glatt aus der Austrittsöffnung 10 der unteren Stirnwand 8 aus, und zwar durch einen biegbaren Schlauch 24, der an der Öffnung 10 befestigt ist und das Hochklappen der Haube 5 zulässt. Der biegbare Schlauch 24 ist im weiteren Verlauf zu dem Lüftermodul 14 mit einer anschließenden Rohrleitung 25 gekoppelt. Der zugehörige Lüfter 15 fördert mit seiner "Druckseite" die erwärmte Abluft aus den Öffnungen 4 in dem Deckel 2a heraus.

Es wird betont, dass alle offenbarten Merkmale auf jede sinnvolle Weise einzeln miteinander kombinierbar sind.

## Patentansprüche

1. Unterflurverteiler für elektrische und/oder elektronische Einrichtungen (6) insbesondere der Telekommunikation, mit einem unterflur in den Boden einbaubaren Schacht (1), der Deckel (2) und eine luftdichte Haube (5) aufweist, in der die elektrischen und/oder elektronischen Einrichtungen (6) angeordnet sind, wobei die Haube (5) aus einer horizontalen Lage in eine vertikale Lage hochklappbar ist,
wobei ein Deckel (2a) Öffnungen für kalte Zuluft (3) und warme Abluft (4) aufweist, die mit zugehörigen Lüftermodulen (14) in Verbindung stehen, die jeweils einen in einer Schutzhaube (16) angeordneten Lüfter (15) aufweisen, wobei von dem Lüftermodul (14) der Zuluft-Druckseite wenigstens eine Rohrleitung (18) in die Haube (5) führt, deren Innenraum von der unter Druck zugeführten Zuluft durchströmt wird,
und wobei die in der Haube (5) erwärmte Abluft aus der Haube (5) heraus und in das Lüftermodul (14) der Abluft-Saugseite eingesaugt wird, um von dort durch die Öffnung (4) in dem Deckel (2a) abgeführt zu werden, wobei in dem Schacht (1) eine Querwand (11) einen Technikraum (12) von einem Einbauraum (13) trennt, der die Haube (5) mit den elektrischen/elektronischen Einrichtungen (6) enthält, und
dass die Lüftermodule (14) in dem Technikraum (12) angeordnet sind.

2. Unterflurverteiler nach Anspruch 1,
**dadurch gekennzeichnet,**
**dass** das Lüftermodul (14) der Kaltluft-Druckseite Filter aufweist, durch die die durchströmende Kaltluft gereinigt wird.

3. Unterflurverteiler nach Anspruch 1,
**dadurch gekennzeichnet,**
**dass** die luftdichte Haube (5) eine schwenkbare Tür (7) aufweist, die wenigstens eine, vorzugsweise zwei Eintrittsöffnungen (9) der Kaltluft hat.

4. Unterflurverteiler nach Anspruch 3,
**dadurch gekennzeichnet,**
**dass** die Zuluft durch Rohre (18) zu der wenigstens einen, vorzugsweise zwei Eintrittsöffnungen (9) geführt ist.

5. Unterflurverteiler nach einem der Ansprüche 1 bis 4,
**dadurch gekennzeichnet,**
**dass** die luftdichte Haube (5) neben der schwenkbaren Tür (7) einen festen Wandabschnitt (8) aufweist, der wenigstens eine Austrittsöffnung (10) der Abluft hat.

6. Unterflurverteiler nach Anspruch 5,
**dadurch gekennzeichnet,**
**dass** in der wenigstens einen Austrittsöffnung (10) ein biegsamer Schlauch (24) befestigt ist, der mit zu dem zugehörigen Lüftermodul führenden Rohren (25) gekoppelt ist.

7. Unterflurverteiler nach einem der Ansprüche 1 bis 6,
**dadurch gekennzeichnet,**
**dass** in der luftdichten Haube (5) Leitbleche (19, 22) angeordnet sind, die den Luftstrom entlang der Innenwand der Haube (5) von der wenigstens einen Eintrittsöffnung (9) zu der wenigstens einen Austrittsöffnung (10) führen.

8. Unterflurverteiler nach einem der Ansprüche 1 bis 7,
**dadurch gekennzeichnet,**
**dass** die Lüfter (15) lastabhängig geregelt werden.

## Claims

1. An underfloor distributor for electrical and/or electronic devices (6), particularly for telecommunications, with a duct (1) which is installable in the ground under the floor, which includes lid (2) and an airtight cap (5), in which the electrical and/or electronic devices (6) are arranged, wherein the cap (5) is arranged to be pivotable upwardly out of a horizontal position into a vertical position, wherein a cover (2a) includes openings for cold supply air (3) and warm exhaust air (4), which communicate with associated fan modules (14), which have a respective fan (15) arranged in a protective hood (16), wherein at least one conduit (18) leads from the fan module (14) of the supply air pressure side into the cap (5), through the interior of which the supply air supplied under pressure flows, and wherein the exhaust air heated in the cap (5) is drawn out of the cap (5) into the fan module (14) of the exhaust air suction side in order to be discharged from there through the opening (4) in the cover (2a), wherein a partition wall (11) in the duct (1) separates an equipment space (12) from an installation space (13), which contains the cap (5) with the electrical/electronic devices (6) and that the fan modules (14) are arranged in the equipment space (12).

2. An underfloor distributor as claimed in Claim 1, **characterised in that** the fan module (14) of the cold air pressure side includes filters, by which the cold air flowing through is cleaned.

3. An underfloor distributor as claimed in Claim 1, **characterised in that** the airtight cap (5) includes a pivotable door (7), which has at least one, preferably two, inlet openings (9) for the cold air.

4. An underfloor distributor as claimed in Claim 3, **characterised in that** the supply air is conducted through pipes (18) to the at least one, preferably two, inlet openings (9).

5. An underfloor distributor as claimed in one of Claims 1 to 4, **characterised in that** in addition to the pivotable door (7) the airtight cap (5) includes a fixed wall section (8), which has at least one outlet opening (10) for the exhaust air.

6. An underfloor distributor as claimed in Claim 5, **characterised in that** fastened in the at least one outlet opening (10) there is a flexible hose (24), which is coupled to pipes (25) leading to the associated fan module.

7. An underfloor distributor as claimed in one of Claims 1 to 6, **characterised in that** arranged in the airtight cap (5) are guide plates (19, 22), which guide the air flow along the inner wall of the cap (5) from the at least one inlet opening (9) to the at least one outlet opening (10).

8. An underfloor distributor as claimed in one of Claims 1 to 7, **characterised in that** the fans (15) are controlled in dependence on load.

## Revendications

1. Répartiteur encastré pour dispositifs électriques et/ou électroniques (6) en particulier de la télécommunication, avec un puits (1) pouvant être monté encastré dans le sol, qui présente un couvercle (2) et un capot étanche à l'air (5), dans lequel les dispositifs électriques et/ou électroniques (6) sont agencés, dans lequel le capot (5) est relevable d'une position horizontale à une position verticale,
dans lequel un couvercle (2a) présente des ouvertures pour l'air entrant froid (3) et l'air sortant chaud (4), qui communiquent avec des modules de ventilateur associés (14), qui présentent respectivement un ventilateur (15) agencé dans un capot de protection (16),
dans lequel au moins une conduite (18) conduit du module de ventilateur (14) du côté pression d'air entrant au capot (5), dont l'espace intérieur est traversé par l'air entrant amené sous pression,
et dans lequel l'air sortant chauffé dans le capot (5) est aspiré hors du capot (5) et aspiré dans le module de ventilateur (14) du côté aspiration d'air sortant, pour être évacué de là par l'ouverture (4) dans le couvercle (2a),
dans lequel
dans le puits (1), une paroi transversale (11) sépare un espace technique (12) d'un espace de montage (13), qui contient le capot (5) avec les dispositifs électriques / électroniques (6), et
que les modules de ventilateur (14) sont agencés dans l'espace technique (12).

2. Répartiteur encastré selon la revendication 1,
**caractérisé en ce**
**que** le module de ventilateur (14) du côté pression d'air froid présente des filtres par lesquels l'air froid traversant est nettoyé.

3. Répartiteur encastré selon la revendication 1,
**caractérisé en ce**
**que** le capot étanche à l'air (5) présente une porte pivotante (7), qui a au moins une, de préférence deux ouvertures d'entrée (9) de l'air froid.

4. Répartiteur encastré selon la revendication 3,
**caractérisé en ce**
**que** l'air entrant est guidé par des tubes (18) vers l'au moins une, de préférence deux ouvertures d'entrée (9).

5. Répartiteur encastré selon l'une quelconque des revendications 1 à 4,
**caractérisé en ce**
**que** le capot étanche à l'air (5) présente à côté de la porte pivotante (7) une section de paroi fixe (8), qui a au moins une ouverture de sortie (10) de l'air sortant.

6. Répartiteur encastré selon la revendication 5,
**caractérisé en ce**
**qu'**un tuyau flexible (24), qui est couplé à des tubes (25) conduisant au module de ventilateur associé, est fixé dans l'au moins une ouverture de sortie (10).

7. Répartiteur encastré selon l'une quelconque des revendications 1 à 6,
**caractérisé en ce**
**que** des déflecteurs (19, 22), qui conduisent le flux d'air le long de la paroi intérieure du capot (5) de l'au moins une ouverture d'entrée (9) à l'au moins une ouverture de sortie (10), sont agencés dans le capot étanche à l'air (5).

8. Répartiteur encastré selon l'une quelconque des revendications 1 à 7,
**caractérisé en ce**
**que** les ventilateurs (15) sont réglés en fonction de la charge.
